# EUROPÄISCHE PATENTSCHRIFT

(11) **EP 0 342 321 B1**
(45) Veröffentlichungstag und Bekanntmachung des Hinweises auf die Patenterteilung: **19.05.1993**
(21) Anmeldenummer: 89103697.2
(22) Anmeldetag: 03.03.1989
(51) Int. Cl.: G01R 31/32

(54) **Prüfkreis für die synthetische Prüfung von Hochspannungsleistungsschaltern**
Circuits for the synthetic testing of high-voltage breakers
Circuit pour le test synthétique d'interrupteurs de puisance à haute tension

(30) Priorität: 15.04.1988 CH 1400/88
(43) Veröffentlichungstag der Anmeldung: 23.11.1989
(73) Patentinhaber: ASEA BROWN BOVERI AG, 5400 Baden (CH)
(72) Erfinder: Schett, Georg, CH-8405 Winterthur (CH)

(56) Entgegenhaltungen:
- EP-A- 0 235 389
- DE-A- 1 135 095
- DE-A- 1 180 841

## Beschreibung

### TECHNISCHES GEBIET

Die Erfindung geht aus von einem Prüfkreis für die synthetische Prüfung des Ausschaltvermögens von Hochspannungs-Leistungsschaltern. Insbesondere betrifft sie einen Prüfkreis mit einem einen Prüfschalter und mindestens einen mit diesem in Reihe geschalteten Hilfsschalter enthaltenden Hochstromkreis und mit mindestens einem Hochspannungskreis. Der mindestens eine Hochspannungskreis ist mittels einer Funkenstrecke auf den Prüfschalter draufschaltbar.

### STAND DER TECHNIK

Aus der DE-AS 11 80 841 ist ein gattungsgemässer Prüfkreis bekannt. Bei diesem Prüfkreis, welcher nach dem bekannten Spannungsüberlagerungsprinzip arbeitet, wird eine aufgeladene, vergleichsweise grosse Kondensatorbatterie als Energiequelle benutzt, welche den wesentlichen Anteil der wiederkehrenden Spannung nach einer Abschaltung des Prüfschalters liefert. Der überwiegende Anteil der in dieser Kondensatorbatterie gespeicherten Energie kann jedoch, wie allgemein bekannt ist, für die Prüfung nicht genutzt werden. Auch bei Prüfkreisen, die nach dem bekannten Stromüberlagerungsprinzip arbeiten, wird die gespeicherte Energie der entsprechenden Kondensatorbatterie überwiegend nicht genutzt. Die zu prüfende Ausschaltleistungen steigen jedoch weiterhin an, so dass vergleichsweise grössere und leistungsstärkere Kondensatorbatterien benötigt werden, wenn diese konventionellen synthetischen Prüfkreise weiter benutzt werden sollen. Der Platzbedarf und auch der finanzielle Aufwand für eine derartige Vergrösserung der Kondensatorbatterien sprengt jedoch den wirtschaftlich vertretbaren Rahmen.

### DARSTELLUNG DER ERFINDUNG

Hier will die Erfindung Abhilfe schaffen. Die Erfindung, wie sie in den Ansprüchen gekennzeichnet ist, löst die Aufgabe einen Prüfkreis für die synthetische Prüfung des Ausschaltvermögens von Hochspannungs-Leistungsschaltern zu schaffen, welcher erlaubt, mit einer vergleichsweise kleinen Kondensatorbatterie eine wirklichkeitsnahe Beanspruchung des Prüfschalters zu erreichen bzw. bestehende Kondensatorbatterien besser auszunutzen und so ohne zusätzliche Investitionen eine Steigerung des prüfbaren Ausschaltvermögens zu erreichen.

Durch die Erfindung ist es vorteilhaft möglich sowohl Spannungsüberlagerungs- als auch Stromüberlagerungs-Prüfkreise wirtschaftlich aufzubauen. Zudem wird der Raumbedarf für diese Prüfkreise wesentlich kleiner bzw. kann der verfügbare Raum für die Prüfung höherer Ausschaltleistungen genutzt werden. Bei den herkömmlichen synthetischen Prüfkreisen wird im Hochspannungskreis eine leistungsstarke Kondensatorbatterie auf Hochspannung aufgeladen. Mittels einer Funkenstrecke wird diese Kondensatorbatterie auf einen RLC-Schwingkreis des Hochspannungskreises und dieser gleichzeitig zeitgenau auf den Prüfschalter draufgeschaltet. Der RLC-Schwingkreis ist so dimensioniert, dass dessen Einschwingen auf die Ladespannung der Kondensatorbatterie die durch internationale Prüfvorschriften vorgeschriebene transiente wiederkehrende Spannung über dem Prüfschalter nachbildet. Voraussetzung hierfür ist jedoch eine etwa zehnmal grössere Kapazität der Kondensatorbatterie als die Kapazität des Kondensators des RLC-Schwingkreises. Daraus ergibt sich, dass nur etwa 10 % der in der Kondensatorbatterie gespeicherten Energie auch tatsächlich für die Prüfung des Abschaltvermögens benutzt werden.

Der erfindungsgemässe Prüfkreis benötigt diese leistungsstarke, für die volle Prüfspannung ausgelegte, aufwendige Kondensatorbatterie nicht mehr und kann deshalb wirtschaftlicher erstellt werden.

Ferner sind mit vergleichsweise kleinem Aufwand an Kondensatoren sehr einfach niederfrequente Schwingkreise im Hochspannungskreis zu erstellen, wie sie beispielsweise für Prüfungen von Leistungsschaltern unter Phasenoppositionsbedingungen oder bei Prüfung des kapazitiven Ausschaltvermögens benötigt werden.

Die weiteren Ausgestaltungen der Erfindung sind Gegenstände der abhängigen Ansprüche.

Die Erfindung, ihre Weiterbildung und die damit erzielbaren Vorteile werden nachstehend anhand der Zeichnungen, welche lediglich einen Ausführungsweg darstellen, näher erläutert.

Es zeigen:
- Fig. 1: eine erste Ausführungsform eines erfindungsgemässen Prüfkreises,
- Fig. 2: eine zweite Ausführungsform eines erfindungsgemässen Prüfkreises,
- Fig. 3: eine dritte Ausführungsform eines erfindungsgemässen Prüfkreises, und
- Fig. 4: eine vierte Ausführungsform eines erfindungsgemässen Prüfkreises.

Bei allen Figuren sind gleich wirkende Elemente mit gleichen Bezugszeichen versehen.

### WEGE ZUR AUSFÜHRUNG DER ERFINDUNG

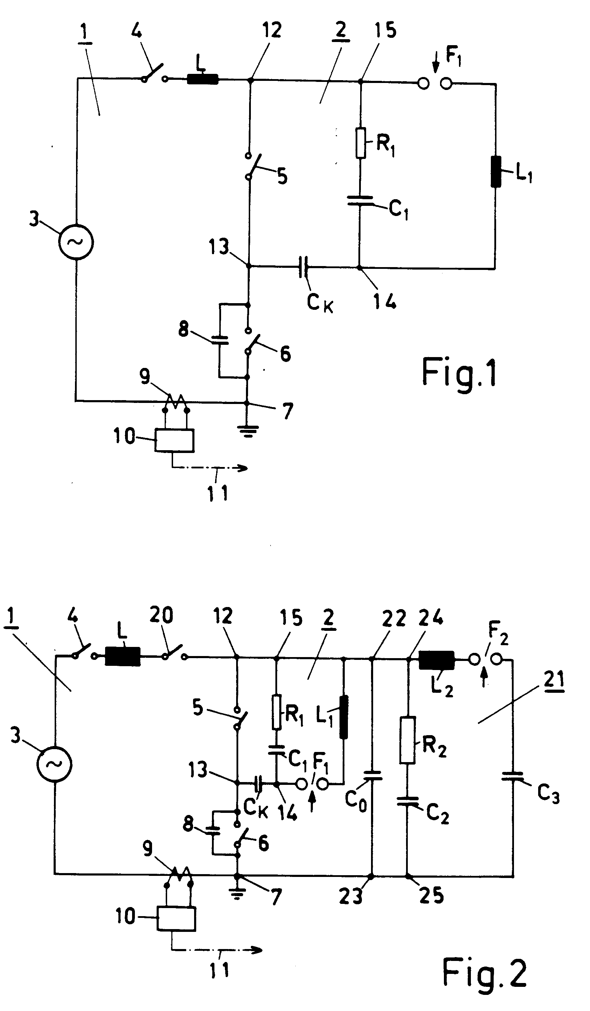

In der Figur 1 ist ein aus einem Hochstromkreis 1 und aus einem Hochspannungskreis 2 bestehender Prüfkreis dargestellt. Der Hochstromkreis 1 enthält eine Reihenschaltung einer Spannungsquelle 3, eines DRaufschalters 4, einer Induktivität L, eines Hilfsschalters 5 und eines Prüfschalters 6. Zwischen dem Prüfschalter 6 und der Spannungsquelle 3 ist eine geerdete Klemme 7 angeordnet. Parallel zum Prüfschalter 6 ist eine Kapazität 8 eingezeichnet. Diese Kapazität 8 weist einen Wert von ca. 1 bis 5 nF auf, sie kann als Schaltungselement eingebaut werden, in vielen Fällen genügt jedoch bereits die Eigenkapazität des offenen Prüfschalters, die sowieso vorhanden ist. Ueber einen beispielsweise als Stromwandler ausgebildeten Sensor 9 werden bei geschlossenem Hochstromkreis 1 stromproportionale Signale abgegriffen und in eine elektronische Steuereinheit 10 zur weiteren Verarbeitung geleitet. Eine die Steuereinheit 10 verlassende Wirkungslinie 11 deutet an, dass die in der Steuereinheit 10 generierten Signale auf weitere Teile des Prüfkreises einwirken. Der Hochstromkreis 1 ist stark vereinfacht dargestellt, so sind beispielsweise sämtliche Einrichtungen, welche dem Schutz der Spannungsquelle 3 dienen, nicht dargestellt.

Parallel zum Hilfsschalter 5 und über Klemmen 12, 13 mit dem Hochstromkreis 1 verbunden ist der Hochspannungskreis 2 geschaltet. Von der zwischen dem Hilfsschalter 5 und dem Prüfschalter 6 angeordneten Klemme 13 führt eine Verbindung über einen Koppelkondensator C_{K} zu einer Klemme 14. Die Klemme 12 ist mit einer Klemme 15 elektrisch leitend verbunden. Zwischen den Klemmen 14 und 15 liegt eine Reihenschaltung eines Kondensators C₁ mit einem Widerstand R₁ und parallel dazu eine Reihenschaltung einer triggerbaren Funkenstrecke F₁ mit einer Induktivität L₁.

Zur Erläuterung der Wirkungsweise sei die Fig. 1 näher betrachtet. Vor dem Beginn der Prüfung ist der Draufschalter 4 offen und sowohl der Hilfsschalter 5 als auch der Prüfschalter 6 sind geschlossen. Ueber die Klemme 14 werden die beiden Kondensatoren C_{K} und C₁ auf den Wert der Prüfspannung aufgeladen. Die hierfür nötige Ladequelle ist nicht dargestellt. Falls der Versuchsschalter 6 nicht geschlossen ist, muss dabei die Klemme 13 hochohmig geerdet sein. Da der Koppelkondensator einen Kapazitätswert von etwa 10 bis 20 nF und der Kondensator C₁ einen Wert im Bereich von 100 nF bis 1 MikroFarad aufweist, genügt hier eine Ladequelle mit vergleichsweise kleiner Leistung. Die Funkenstrecke F₁ ist so eingestellt, dass sie bei diesem Wert der Prüfspannung noch nicht durchzündet. Durch den Draufschalter 4 wird dann der Hochstromkreis 1 geschlossen und ein durch die Spannungsquelle 3 gespeister Prüfstrom beginnt zu fliessen. Gemäss dem bekannten Prinzip der Spannungsüberlagerung wird sowohl der korrekte Prüfstrom als auch der erste Anstieg der wiederkehrenden Spannung während ca. 20 Mikrosekunden durch die Spannungsquelle 3 sichergestellt. Der Hochspannungskreis 2 wird durch ein durch die Steuereinheit 10 zeitgenau gesteuertes Durchzünden der Funkenstrecke F₁ auf den Prüfschalter 6 draufgeschaltet.

Nach dem gleichzeitigen Abschalten des Hilfsschalters 5 und des Prüfschalters 6, sorgt ein Spannungsteiler, der aus dem Kondensator C₁ und der Kapazität 8 besteht, dafür, dass zunächst in den etwa 20 Mikrosekunden nach der Unterbrechung des Hochstromkreises 1, die von der Spannungsquelle 3 gelieferte Spannung nahezu vollständig über dem Prüfschalter 6 abfällt. Der Hilfsschalter 5 hat dabei beim Löschen keine Probleme, da er nur eine vernachlässigbare wiederkehrende Spannung beherrschen muss. Nach dem zeitgenauen Draufschalten des Hochspannungskreises 2 nach dem ersten Anstieg der wiederkehrenden Spannung, liegt die gesamte vom Hochspannungskreis 2 gelieferte Spannung an der Klemme 13 und beaufschlagt den Prüfschalter 6. Diese vom Hochspannungskreis 2 gelieferte Spannung setzt sich zusammen aus der stationären Prüfspannung, die der aufgeladene Koppelkondensator C_{K} liefert, und dem durch einen auf Null ausschwingenden Schwingkreis, der aus dem Kondensator C₁, dem Widerstand R₁ und der Induktivität L₁ besteht, gelieferten transienten Anteil der Prüfspannung.

Der Koppelkondensator C_{K} könnte auch zwischen den Klemmen 12 und 15 angeordnet werden, ohne die Funktionsfähigkeit des Hochspannungskreises 2 zu beeinträchtigen. Die Aufladung der Kondensatoren C₁ und C_{K} müsste bei dieser Schaltungsvariante jedoch von der Klemme 15 her erfolgen, wobei der Hilfsschalter 5 und der Prüfschalter 6 geschlossen sein, bzw. die Klemme 12 hochohmig geerdet sein müsste.

In Fig. 2 ist ein synthetischer Prüfkreis dargestellt, der nach dem Prinzip der Stromüberlagerung arbeitet. Neben dem Hochstromkreis 1, der gegenüber dem der Fig. 1 einen zusätzlichen Hilfsschalter 20 aufweist, und dem leicht modifizierten Hochspannungskreis 2 ist ein weiterer Hochspannungskreis 21 vorgesehen. Dieser Hochspannungskreis 21 ist über die Klemmen 12 und 7 parallel zu der Reihenschaltung des Hilfsschalters 5 mit dem Prüfschalter 6 gelegt und auf der Seite der Klemme 12 mit dem Hochspannungskreis 2 verbunden. Parellel zu der Reihenschaltung des Hilfsschalters 5 mit dem Prüfschalter 6 ist zwischen Klemmen 22 und 23 ein Kondensator Co geschaltet, mit dessen Hilfe das t_{d} (time-delay) der wiederkehrenden Spannung eingestellt werden kann. Die Klemme 22 ist elektrisch leitend mit einer Klemme 24 und die Klemme 23 mit einer Klemme 25 verbunden. Zwischen den Klemmen 24 und 25 liegt eine Reihenschaltung eines Widerstandes R₂ mit einer Kapazität C₂ parallel zu einer Reihenschaltung einer Induktivität L₂, einer Funkenstrecke F₂ und einer Kondensatorbatterie C₃.

Die Funktion des Prüfkreises gemäss Fig. 2 sei nachfolgend beschrieben. ImHochstromkreis 1 sind die Hilfsschalter 5 und 20 und der Prüfschalter 6 zunächst geschlossen, der Draufschalter 4 ist offen. Die Kondensatoren C₁ und C_{K} des Hochspannungskreises 2 werden von der Klemme 14 her auf die volle Prüfspannung aufgeladen. Die Kondensatorbatterie C₃ des Hochspannungskreises 21 wird in der Regel von einer nicht dargestellen Quelle auf ca. 50 kV aufgeladen, also auf einen Spannungswert weit unterhalb der vollen Prüfspannung. Die Funkenstrecke F₂ zündet bei der Ladespannung von C₃ noch nicht durch. Die Kondensatorbatterie C₃ kann, da sie nur für eine vergleichsweise niedrige Hochspannung ausgelegt ist auf kleinem Raum und mit wenig Aufwand erstellt werden, während die Kondensatorbatterien, die in herkömmlichen Prüfkreisen als Energiequelle benutzt werden, für die volle Prüfspannung ausgelegt werden müssen und entsprechend aufwendig zu erstellen sind. Sie müssen zudem der jeweiligen Prüfspannung von Fall zu Fall angepasst werden, was nur mit grossem Montage- und Umschaltaufwand realisiert werden kann, während die Kondensatorbatterie C₃ im Normalfall für alle Betriebsspannungen immer gleich geschaltet ist. Ferner genügt eine vergleichsweise schwache und billigere Ladequelle für deren Aufladung auf die ca. 50 kV.

Mit dem Schliessen des Draufschalters 4 beginnt der Prüfstrom im Hochstromkreis 1 zu fliessen. Unmittelbar vor dem für die Löschung vorbestimmten Nulldurchgang des Prüfstromes wird die Funkenstrecke F₂ durch die Steuereinheit 10 zeitgenau ausgelöst und ein durch die Kondensatorbatterie C₃ gespeister Schwingstrom beginnt zu fliessen und überlagert sich dem Prüfstrom. Der Hilfsschalters 20 löscht zuerst und unterbricht den Hochstromkreis 1. Durch den Hilfsschalter 5 und den Prüfschalter 6 fliesst der Schwingstrom weiter und wird im ersten Nulldurchgang abgeschaltet. Die wiederkehrende Spannung unmittelbar nach dieser Abschaltung erscheint aufgrund des aus dem Kondensator C₁ und der Kapazität 8 bestehenden Spannungsteilers jedoch nahezu vollständig über dem nun offenen Prüfschalter 6. Auch hier werden um den Löschzeitpunkt herum Strom und Spannung aus der gleichen Spannungsquelle geliefert und der Prüfschalter in dieser Phase damit realitätskonform beaufschlagt. Diese Phase wird als thermische Phase des Löschvorganges bezeichnet, da hier im Falle eines Schaltversagens ein thermisches Wiederzünden im Prüfschalter 6 auftreten würde. Kurz vor dem Erreichen der Hochspannung, die der Hochspannungskreis 21 maximal liefern kann, wird die Funkenstrecke F₁ von der Steuereinheit 10 her gezündet und damit der Hochspannungskreis 2 auf den Prüfschalter 6 draufgeschaltet, welcher den weiteren Anstieg der wiederkehrenden Spannung, wie bereits früher beschrieben, sicherstellt.

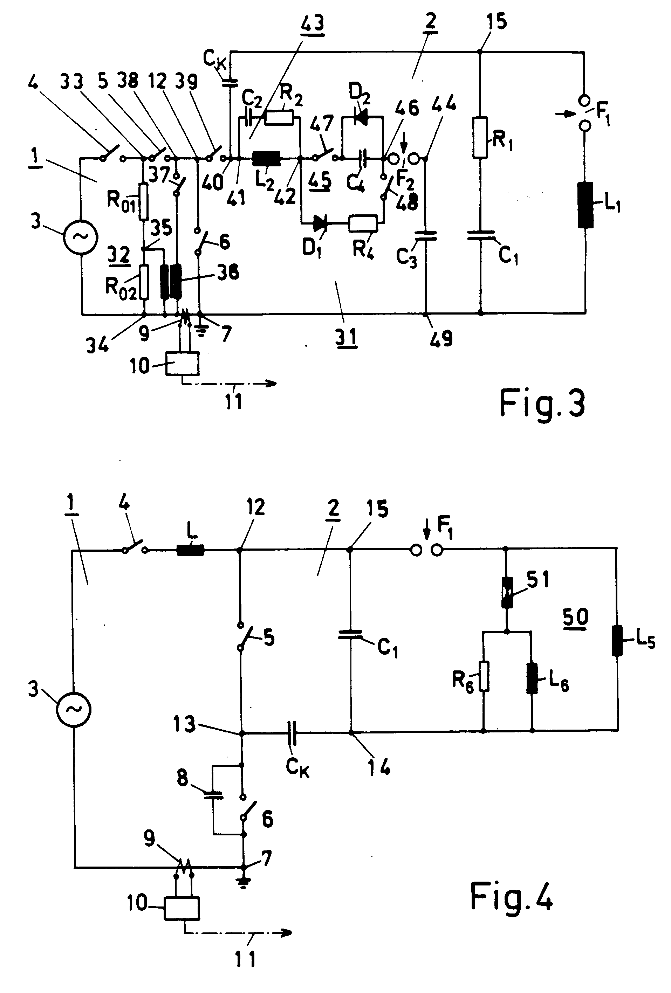

In Fig. 3 ist ein weiterer synthetischer Prüfkreis dargestellt, der nach dem Prinzip der Stromüberlagerung arbeitet. Neben dem Hochstromkreis 1 und dem Hochspannungskreis 2 sind zwei weitere Hochspannungskreise 31, 32 vorgesehen. Der Hochspannungskreis 31 liefert den Schwingstrom und die wiederkehrende Spannung während der thermischen Phase, daran anschliessend liefert der Hochspannungskreis 2 den weiteren Anstieg der wiederkehrenden Spannung bis zu deren Maximalwert, der dann eine sinusförmige Betriebsspannung, die vom Hochspannungskreis 32 herrührt, überlagert wird.

Der Hochstromkreis 1 ist ähnlich aufgebaut wie in Fig. 1. Parallel zur Spannungsquelle 3, welche bei geschlossenem Draufschalter 4 auch die Wechselspannungsquelle für den Hochspannungskreis 32 bildet ist zwischen Klemmen 33 und 34 ein Spannungsteiler aus Widerständen R₀₁ und R₀₂ aufgebaut, der einen Mittelabgriff 35 aufweist. Der Mittelabgriff 35 ist mit der einen Seite der Unterspannungswicklung eines Transformators 36 verbunden, deren andere Seite auf Erdpotential liegt. Die Oberspannungswicklung liegt ebenfalls einseitig an Erde, während ihre andere Seite über einen Hilfsschalter 37 mit einer Klemme 38 verbunden und so parallel zum Prüfschalter 6 geschaltet werden kann. Der Transformator 36 kann vorteilhaft als Spannungswandler ausgebildet sein.

Die Klemme 12 des Hochstromkreises 1 ist über einen Hilfsschalter 39 mit einer Klemme 40 verbunden. Die Klemme 40 ist mit einer Klemme 41 elektrisch leitend verbunden. Zwischen die Klemme 41 und eine Klemme 42 ist ein Einstellglied 43 zwischengeschaltet, welches aus einer Reihenschaltung eines Kondensators C₂ mit einem ohmschen Widerstand R₂ besteht, zu welcher eine Induktivität L₂ parallelgeschaltet ist. Zwischen der Klemme 42 und einer Klemme 44 liegt eine triggerbare Schaltstelle 45. Diese triggerbare Schaltstelle 45 besteht aus einer triggerbaren Funkenstrecke F₂ als Einschaltgerät, welche zwischen der Klemme 44 und einer Klemme 46 angeordnet ist, und einer zwischen den Klemmen 42 und 46 liegenden Schaltungsanordnung. Ein erster Zweig dieser Schaltungsanordnung enthält eine Reihenschaltung eines aus mindestens einer Vakuumschaltröhre bestehenden Schaltelementes 47 mit einem von einer nicht dargestellten Gleichspannungsquelle her aufladbaren Kondensator C₄, der als Niederspannungskondensator ausgebildet ist, zu welchem eine Diode D₂ parallelgeschaltet ist. Diese Diode D₂ ist für Ströme, welche von der Klemme 46 her eingespeist werden, durchlässig. Ein zweiter, zum ersten paralleler Zweig der Schaltungsanordnung enthält eine Reihenschaltung einer Diode D₁, eines ohmschen Widerstandes R₄ und einer Unterbrechungsstelle 48, wobei die Diode D₁ für Ströme durchlässig ist, welche von der Klemme 42 her eingespeist werden. Zwischen die Klemme 44 und eine Klemme 49, welche mit der Klemme 7 leitend verbunden ist, ist die Kondensatorbatterie C₃ geschaltet.

Die Klemme 40 ist zudem über den Koppelkondensator C_{K} des Hochspannungskreises 2 verbunden mit der Klemme 15. Die Klemme 15 ist über die Reihenschaltung des Widerstandes R₁ mit dem Kondensator C₁ und über die Reihenschaltung der Funkenstrecke F₁ mit der Induktivität L₁ mit der Klemme 49 verbunden.

Zur Erläuterung der Wirkungsweise des Prüfkreises sei die Figur 3 näher betrachtet. Die Hilfsschalter 5 und 39, das Schaltelement 47 und der Prüfschalter 6 sind zunächst geschlossen, der Draufschalter 4 und die Unterbrechungsstelle 48 sind dagegen offen. Der Kondensator C₄, der eine Kapazität von ca. 2 bis 15 mF aufweist, wird mit Niederspannung aufgeladen auf eine Spannung im Bereich von 100 V bis einige 100 V. Die Kondensatorbatterie C₃ wird über die Klemme 44 mit einer Hochspannung von ca. 50 kV aufgeladen. Die Kondensatoren C_{K} und C₁ werden von der Klemme 15 her auf die volle Betriebsspannung aufgeladen. Der Draufschalter 4 wird geschlossen und der Prüfstrom beginnt im Hochstromkreis 1 zu fliessen. Der Prüfschalter 6 und der Hilfsschalter 5 werden geöffnet. Unabhängig davon wird in einem geeigneten Zeitpunkt die Unterbrechungsstelle 48 geschlossen, und der Kondensator C₂ speist einen Entladestrom über das geschlossene Schaltelement 47, die Diode D₁ und den Widerstand R₄, welcher diesen Entladestrom begrenzt. Danach öffnet sich das geschlossene Schaltelement 47, welches hier als mindestens eine Vakuumschaltröhre ausgebildet ist, der Entladestrom fliesst jedoch weiter über den in dieser Vakuumschaltröhre bestehenden Lichtbogen.

Der zeitliche Ablauf der gesamten Schaltvorgänge wird von der Steuereinheit 10, die vorab entsprechend eingestellt worden ist, gesteuert. Vom Sensor 9 gelangen zum Prüfstrom proportionale Signale in die Steuereinheit 10 und werden dort in zeitgenaue Triggersignale umgesetzt. Eines dieser Triggersignale wirkt auf die Funkenstrecke F₂ ein und bringt sie zum Durchzünden. Die Schaltstelle 45 ist, dank dem noch bestehenden Lichtbogen im Schaltelement 47 leitend für einen von der Kondensatorbatterie C₃ gespeisten Schwingstrom. Dieser Schwingstrom entlädt zunächst den Kondensator C₄ und der Entladestrom wird dadurch Null. Danach kommutiert der Schwingstrom auf die Strombahn durch die Diode D₂. Der Schwingstrom fliesst somit im Hochspannungskreis 31 durch die Schaltstelle 45, durch das Einstellglied 43, durch den Hilfsschalter 39 sowie den Prüfschalter 6 und überlagert sich dem Prüfstrom. Sobald dann der Prüfstrom durch Null geht, löscht der Hilfsschalter 5. Durch den Prüfschalter 6 fliesst dann nur noch der Schwingstrom, dessen Steilheit unmittelbar vor dem Stromnulldurchgang genau der Sollsteilheit des Prüfstromes in dessen Nulldurchgang entspricht. Der Prüfschalter 6 löscht den Schwingstrom in seinem Nulldurchgang, gleichzeitig löscht auch das Schaltelement 47. Der Schwingstrom fliesst demnach nur während einer Halbwelle.

Nach dem Erlöschen des Schwingstroms baut sich eine wiederkehrende Spannung über dem Prüfschalter 6 auf, wobei der Verlauf des transienten Anteils dieser Spannung durch den durch das Einstellglied 43 gebildeten ausschwingenden Schwingkreis bestimmt wird. Sollte im Prüfschalter 6 noch eine gewisse Restleitfähigkeit der Abschaltstrecke bestehen, so könnte dort ein thermischer Nachstrom, welcher durch die Kondensatorbatterie C₃ gespeist würde, fliessen. Die thermische Phase des Abschaltvorganges wird demnach realitätskonform geprüft. Kurz vor dem Erreichen der Hochspannung, die der Hochspannungskreis 31 maximal liefern kann, wird die Funkenstrecke F₁ von der Steuereinheit 10 her gezündet und damit der Hochspannungskreis 2 auf den Prüfschalter 6 draufgeschaltet, welcher den weiteren Anstieg der wiederkehrenden Spannung, wie bereits beschrieben, sicherstellt.

Unmittelbar vor dem Abtrennen des Hochspannungskreises 2, durch Oeffnung des Hilfsschalters 39, wird der Hochspannungskreis 32 auf den Prüfschalter 6 draufgeschaltet, indem der Hilfsschalter 37 geschlossen wird. Der Hochspannungskreis 32 ist leistungsschwach, da er nur eine netzfrequente Betriebsspannung für den Prüfschalter 6 liefern muss. Diese netzfrequente Spannung wird von der Spannungsquelle 3 geliefert, dadurch ist sichergestellt, dass diese netzfrequente Spannung phasenrichtig und ohne Unterbrechung zugeschaltet wird. Diese Spannungsbelastung des Prüfschalters 6 kann nun beliebig lange aufrechterhalten werden und dann durch einen zwischen Spannungsquelle 3 und Draufschalter 4 liegenden, nicht dargestellten Leistungsschalter abgeschaltet werden.

In Fig. 4 ist eine Abwandlung des Prüfkreises gemäss Fig. 1 dargestellt. Dieser Prüfkreis eignet sich besonders, wenn eine Vierparameter-TRV erzeugt werden soll, wie sie in der IEC-Vorschrift 427 vorgegeben ist. Der Begriff TRV steht hier für Transient Recovery Voltage (transiente wiederkehrende Spannung). Im Hochspannungskreis 2 werden dabei der Widerstand R₁ und die Induktivität L₁ ersetzt durch eine Schaltungsanordnung 50, die zwischen die Funkenstrecke F₁ und die Klemme 14 geschaltet ist. Diese Schaltungsanordnung 50 besteht aus einer Induktivität L₅, zu welcher eine Reihenschaltung eines Ueberspannungsableiters 51 aus Varistormaterial mit einer Parallelschaltung eines Widerstandes R₆ und einer Induktivität L₆, parallel geschaltet ist.

Der Prüfkreis nach Fig. 4 arbeitet bis zum Zünden der Funkenstrecke F₁ gleich wie der gemäss Fig. 1. Beim Zünden der Funkenstrecke F₁ liegt die volle Spannung des geladenen Kondensators C₁ an der Schaltungsanordnung 50 an. Dies hat zur Folge, dass der Ueberspannungsableiter 51 sofort anspricht und die Induktivitäten L₅ und L₆ parallelschaltet. Im Schwingkreis wirkt also eine vergleichsweise kleine resultierende Induktivität, was eine vergleichsweise hohe Schwingkreisfrequenz und damit auch eine vergleichsweise steile TRV zur Folge hat. Nach dem ersten, von der Spannungsquelle 3 her eingekoppelten Anstieg der TRV, beaufschlagt diese vergleichsweise steile TRV den Prüfschalter 6 weiter. Mit zunehmender Entladung des Kondensators C₂ sinkt auch die am Ueberspannungsableiter 51 anliegende Spannung und er sperrt, sobald seine Ansprechspannung unterschritten wird, so dass jetzt die Induktivität L₅ alleine wirkt. Die im Schwingkreis wirksame Induktivität ist damit grösser und zugleich ist die Schwingkreisfrequenz kleiner geworden, d.h. die TRV steigt ab diesem Augenblick flacher an bis zum eingestellten Maximalwert der Prüfspannung. Derartige, gleich wirkende Modifikationen sind auch bei den übrigen Ausführungsbeispielen möglich.

## Patentansprüche

1. Prüfkreis für die synthetische Prüfung des Ausschaltvermögens von Hochspannungs-Leistungsschaltern mit einem einen Prüfschalter (6) und mindestens einen mit dem Prüfschalter (6) in Reihe geschalteten Hilfsschalter (5, 20) enthaltenden Hochstromkreis (1) und mit mindestens einem mittels einer Funkenstrecke (F₁, F₂) auf den Prüfschalter (6) draufschaltbaren, mindestens eine Hochspannungsquelle (C₁; C₀, C₂, C₃) aufweisenden Hochspannungskreis (2), dadurch gekennzeichnet,
- dass die vom mindestens einen Hochspannungskreis (2) gelieferte Hochspannung über einen Koppelkondensator (C_{K}) auf den Prüfschalter (6) einwirkt, und
- dass dieser Koppelkondensator (C_{K}) als Hochspannungsquelle für die stationäre Prüfspannung dient.

2. Prüfkreis nach Anspruch 1, dadurch gekennzeichnet,
- dass die Hochspannung des mindestens einen Hochspannungskreises (2) nach der Unterbrechung des Hochstromkreises (1) auf den Prüfschalter (6) einwirkt.

3. Prüfkreis nach Anspruch 1, dadurch gekennzeichnet,
- dass die Hochspannung des mindestens einen Hochspannungskreises (2) erst nach der Abschaltung mindestens eines zweiten Hochspannungskreises (21, 31) durch den Prüfschalter (6) auf diesen einwirkt.

4. Prüfkreis nach Anspruch 3, gekennzeichnet durch Mittel, derart, dass der stationären Prüfspannung eine konstante sinusförmige Prüfspannung überlagert werden kann.

## Claims

1. Test circuit for the synthetic testing of the breaking capacity of high-voltage circuit-breakers, having a high-current circuit (1) containing a test switch (6) and at least one auxiliary switch (5, 20) connected in series with the test switch (6), and having at least one high-voltage circuit (2) which can be connected by means of a spark gap (F₁, F₂) to the test switch (6) and has at least one high-voltage source (C₁; C₀, C₂, C₃), characterised in that the high voltage supplied from at least one high-voltage circuit (2) acts on the test switch (6) via a coupling capacitor (C_{K}), and in that said coupling capacitor (C_{K}) serves as high-voltage source for the stationary test voltage.

2. Test circuit according to Claim 1, characterised in that after the interruption of the high-current circuit (1), the high voltage of at least one high-voltage circuit (2) acts on the test switch (6).

3. Test circuit according to Claim 1, characterised in that only after the disconnection at least of a second high-voltage circuit (21, 31) by the test switch (6) does the high voltage of at least one high-voltage circuit (2) act on said test switch.

4. Test circuit according to Claim 3, characterised by means with which a constant sinusoidal test voltage can be superimposed on the stationary test voltage.

## Revendications

1. Circuit d'essai pour l'essai synthétique du pouvoir de coupure d'interrupteurs de puissance à haute tension comportant un circuit pour courant très fort (1) comprenant un interrupteur d'essai (6) et au moins un interrupteur auxiliaire (5, 20) connecté en série avec l'interrupteur d'essai (6) et au moins un circuit à haute tension (2) comportant au moins une source de haute tension (C1; C0, C2, C3) et pouvant être enclenché au moyen d'au moins un éclateur (F₁, F₂) sur l'interrupteur d'essai (6), caractérisé en ce
- que la haute tension fournie par au moins un circuit à haute tension (2) agit, par l'intermédiaire d'un condensateur de couplage (C_{K}), sur l'interrupteur d'essai (6), et
- que ce condensateur de couplage (C_{K}) sert de source de haute tension pour la tension d'essai stationnaire.

2. Circuit d'essai suivant la revendication 1, caractérisé en ce
- que la haute tension du au moins un circuit à haute tension (2) agit sur l'interrupteur d'essai (6) après l'interruption du circuit pour courant très fort (1).

3. Circuit d'essai suivant la revendication 1, caractérisé en ce
- que la haute tension du au moins un circuit à haute tension (2) n'agit sur l'interrupteur d'essai (6) qu'après la désactivation d'au moins un second circuit à haute tension (21, 31) par cet interrupteur d'essai (6).

4. Circuit d'essai suivant la revendication 3, caractérisé par des moyens à l'aide desquels une tension d'essai sinusoïdale constante peut être superposée à la tension d'essai stationnaire.
